# EUROPÄISCHE PATENTSCHRIFT

(11) **EP 1 208 618 B1**
(45) Veröffentlichungstag und Bekanntmachung des Hinweises auf die Patenterteilung: **14.07.2004**
(21) Anmeldenummer: 00969214.6
(22) Anmeldetag: 31.08.2000
(51) Int. Cl.: H01R 13/66, H05K 5/00

(54) **STEUERGERÄT UND LÖTVERFAHREN**
CONTROL DEVICE AND SOLDERING METHOD
APPAREIL DE COMMANDE ET PROCEDE DE SOUDAGE

(30) Priorität: 01.09.1999 DE 19941690
(43) Veröffentlichungstag der Anmeldung: 29.05.2002
(73) Patentinhaber: SIEMENS AKTIENGESELLSCHAFT, 80333 München (DE)
(72) Erfinder: TOST, Michael, 82269 Geltendorf (DE); BEUTHER, Christian, 93051 Regensburg (DE)
(86) Internationale Anmeldenummer: PCT/DE2000/002942
(87) Internationale Veröffentlichungsnummer: WO 2001/017069

(56) Entgegenhaltungen:
- EP-A- 0 854 666
- DE-A- 4 110 579
- DE-A- 4 311 639
- DE-A- 19 706 790
- DE-C- 19 611 699
- US-A- 5 699 235
- US-A- 5 712 765

## Beschreibung

Die Erfindung betrifft ein Steuergerät, insbesondere für die Automobiltechnik, mit einem Gehäuse, einer Leiterplatte, auf der oberflächenmontierbare Bauelemente gelötet sind, und einem Steckverbinder sowie ein Verfahren zum Löten eines bedrahteten Bauelements und von SMT-Bauelementen auf eine Leiterplatte.

Um den zunehmend höheren Ansprüchen an die elektrischen Funktionen und an eine kostengünstige Fertigung bei Steuergeräten der Automobiltechnik zu erfüllen, werden vermehrt diskrete, leistungsfähige elektrische Bauelemente in Steuerschaltungen eingesetzt. Diese Bauelemente existieren allerdings häufig nicht als oberflächenmontierbare Bauelemente (SMD) oder sind nur zu einem weitaus höheren Preis verfügbar als vergleichbare bedrahtete Bauelemente.

Beim Einsatz von zusätzlichen bedrahteten Bauelementen wird der mit SMT-Bauelementen bestückte Teil der Leiterplatte mittels eines Reflow-Lötverfahrens gelötet, und die bedrahteten Bauelemente werden in einem separaten Lötprozeß gelötet. Allerdings können verschiedene diskrete Bauelemente, beispielsweise Elektrolyt-Kondensatoren nicht den hohen Temperaturen ausgesetzt werden, die bei einer Reflow-Lötung auftreten. Außerdem ist ein zusätzlicher Lötprozeß grundsätzlich unerwünscht.

Aus der Offenlegungsschrift DE 197 06 790 A1 ist ein Steuergerät mit einer Leiterplatte bekannt, die teilweise mit oberflächenmontierbaren Bauelementen und teilweise mit bedrahteten Bauelementen bestückt ist. Hierzu ist eine Öffnung in einer Gehäusewand vorgesehen, die gegen Umwelteinflüsse abgedichtet werden muß. An der Gehäuseaußenseite entsteht hierdurch eine Erhebung, die für eine Montage hinderlich sein kann.

EP 0 854 666 A2 betrifft ein Steuergerät mit einem Gehäuse, bei dem auf einer Leiterplatte oberflächenmontierbare Bauelemente gelötet sind, und mit einem Steckverbinder. Ein bedrahtetes Bauelement ist nahe dem Steckverbinder angeordnet. Hierzu weist der Gehäusedeckel eine Seitenwand und einen über den Steckverbinder und das bedrahtete Bauelement ragenden Rand.

Aus DE 41 10 579 A1 ist ein Steckverbinder für elektronische Steuergeräte in Kraftfahrzeugen bekannt, bei dem Bauelemente gegen elektromagnetische Störeinflüsse an der Außenseite des Steckverbinders angebracht sind.

Aus US 5,444,416 ist ein digitales Demodulationsgerät bekannt, bei dem bedrahtete Bauelemente gegen Störeinflüsse in einem Hohlraum eines Steckverbinders auf einer Leiterplatte angebracht sind.

Schließlich ist aus US 5,712,765 ein Elektronikmodul mit einem Gehäuse, einer Leiterplatte und einem Steckverbinder bekannt, wobei der Steckverbinder im montierten Zustand auf der Leiterplatte befestigt ist und ein auf der Leiterplatte angeordnetes elektronisches Bauelement aufnimmt, um die Wärmeableitung von dem elektronischen Bauelement zu verbessern. Die elektronischen Bauelemente werden hierbei vor der Montage des Steckverbinders auf der Leiterplatte angeordnet und anschließend verlötet, so daß die Montage des Steckverbinders und die Vormontage der elektronischen Bauelemente auf der Leiterplatte separate Arbeitsschritte bilden.

Es ist ein Ziel der Erfindung, ein Steuergerät und ein Verfahren zum Löten wenigstens eines bedrahteten Bauelements und von oberflächenmontierbaren Bauelementen auf eine Leiterplatte bereitzustellen, die eine effiziente, kostengünstige und Einbauraum sparende Fertigung von Steuergeräten ermöglichen.

Dieses Ziel wird mit einem Steuergerät und einem Verfahren erreicht, wie sie in den unabhängigen Patentansprüchen definiert sind. Vorteilhafte Ausführungsformen der Erfindung sind in den Unteransprüchen angegeben.

Durch die Unterbringung eines oder mehrerer bedrahteter Bauelemente im Steckverbindergehäuse kann auf ein separates Plazieren des oder der bedrahteten Bauelements auf der Leiterplatte verzichtet werden. Ein bedrahtete Bauelement wird zusammen mit den Kontaktstiften des Steckverbinders in entsprechende Durchkontaktierungen der Leiterplatte eingesetzt.

In einer besonders bevorzugten Ausführungsform ist ein bedrahtetes Bauelement vom Steckverbindergehäuse gekapselt, so daß Bauelemente, die für die bei einem Reflow-Lötverfahren auftretenden sehr hohen Temperaturen nicht geeignet sind, trotzdem bei Temperaturen von 200°C und darüber gelötet werden können. Auf diese Weise können beispielsweise Elektrolyt-Kondensatoren, die einer maximalen Temperatur von 125°C ausgesetzt werden dürfen, in einem Reflow-Lötofen gelötet werden.

Die Unterbringung des bedrahteten Bauelements oder Bauteils in dem Steckverbinder erlaubt eine Verminderung der Leiterplattenfläche. Dies ist besonders vorteilhaft, wenn eine Leiterplatte nur einseitig bestückt werden kann, um beispielsweise auf einer Seite mit einer Wärmesenke in Anlage gebracht zu werden. Wenn hierbei die Leiterplatte mit einer Seite an einer Gehäuseinnenwand und der Steckverbinder auf der der Leiterplatte abgewandten Gehäuseaußenwand angebracht ist, kann ein besonders kompaktes Gehäuse mit einem geringen eingeschlossenen Luftvolumen realisiert werden. Die oberflächenmontierbaren Bauelemente (SMD) und das bedrahtete Bauelement sind hierzu idealerweise auf dieselbe Leiterplatte gelötet.

Das Steckverbindergehäuse kann einstückig mit der Gehäusewand oder dem Gehäusedeckel ausgebildet sein. Bei der Verwendung eines metallischen, metallisierten oder leitfähigen Materials wird eine besonders gute Schirmung des Steuergeräts gegenüber elektromagnetischen Störungen erreicht.

Die Erfindung eignet sich besonders für den Einsatz in Steuergeräten von Kraftfahrzeugen, und insbesondere für Motorsteuergeräte.

Weitere Vorteile, Merkmale und Anwendungsmöglichkeiten der Erfindung ergeben sich aus der nachfolgenden Beschreibung von Ausführungsbeispielen in Verbindung mit den Zeichnungen. Es zeigen:
- Figur: 1 eine Schnittdarstellung eines Steckverbinders,
- Figur 2: eine Unteransicht des Steckverbinders von Figur 1,
- Figur 3: einen Schnitt durch einen Steckverbinder, in den ein Bauelementengehäuse mit einem bedrahteten Bauelement eingesetzt ist,
- Figur 4: ein Bauelementengehäuse mit einem bedrahteten Bauelement, und
- Figur 5: ein Steuergerät, bei dem ein Steckverbinder an eine Leiterplatte gelötet ist.

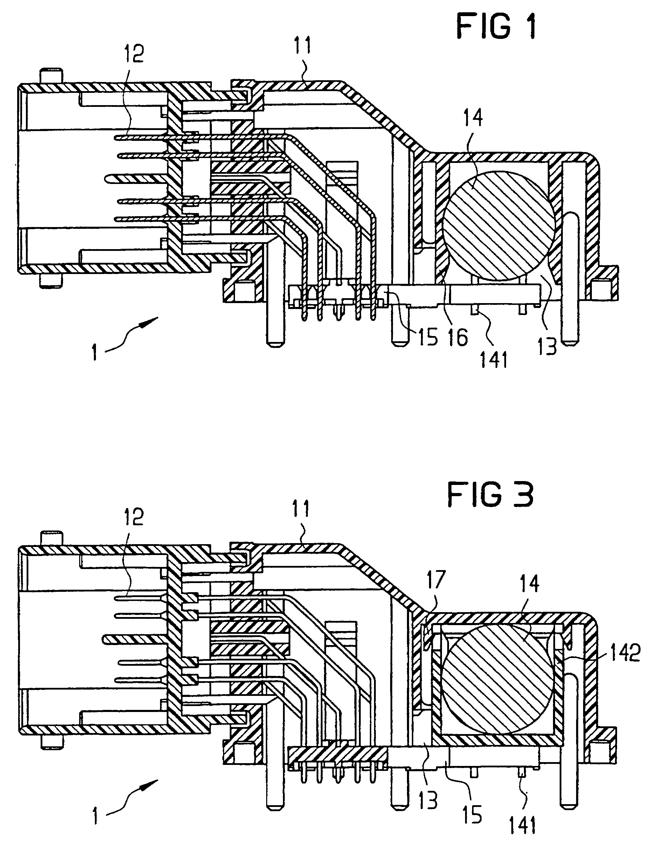

Figur 1 veranschaulicht einen Steckverbinder 1 mit einem Steckverbindergehäuse 11. Im Steckverbindergehäuse 11 sind Kontaktstifte 12 und in einem Hohlraum 13 ein bedrahtetes Bauelement 14 mit Anschlußdrähten 141 angeordnet. Das bedrahtete Bauelement 14 ist ein Elektrolyt-Kondensator. Im Steckverbindergehäuse 11 ist eine Zentrierhilfe 15 mit einem Raster für die Kontaktstifte 12 und die Anschlußdrähte 141 eingesetzt. Die Zentrierhilfe 15 richtet die Kontaktstifte und die Anschlußdrähte auf ein entsprechendes Raster einer Leiterplatte aus, mit der ein elektrischer Kontakt hergestellt werden soll.

Das Steckverbindergehäuse 11 besteht aus einem Kunststoffmaterial. Der Hohlraum 13 wird durch paralelle Stege 16 eingegrenzt. Die Stege 16 weisen Vertiefungen oder Mulden auf, in denen das bedrahtete Bauelement 14 eingerastet und gehalten ist. Die Stege 16 sind einstückig mit dem Steckverbindergehäuse 11 ausgebildet. Letzteres besteht aus einem Kunststoffmaterial.

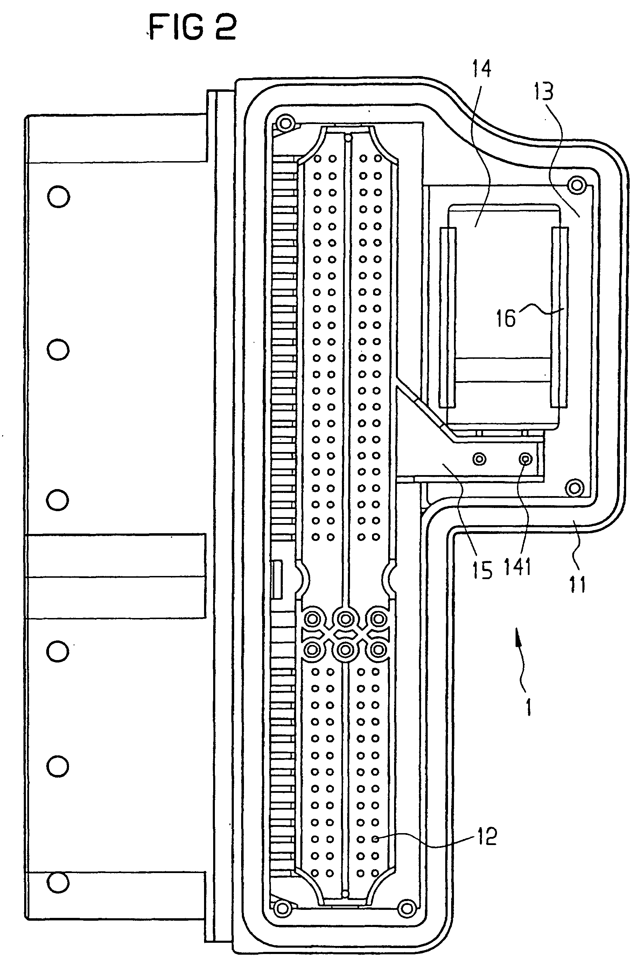

Figur 2 zeigt die an der Unterseite des Steckverbindergehäuses 11 fixierte Zentrierhilfe 15. Sie führt die Kontaktstifte 12 und die Anschlußdrähte 141 in einem definierten Raster.

Das bedrahtete Bauelement wird von Schenkeln oder Stegen 16 umfaßt.

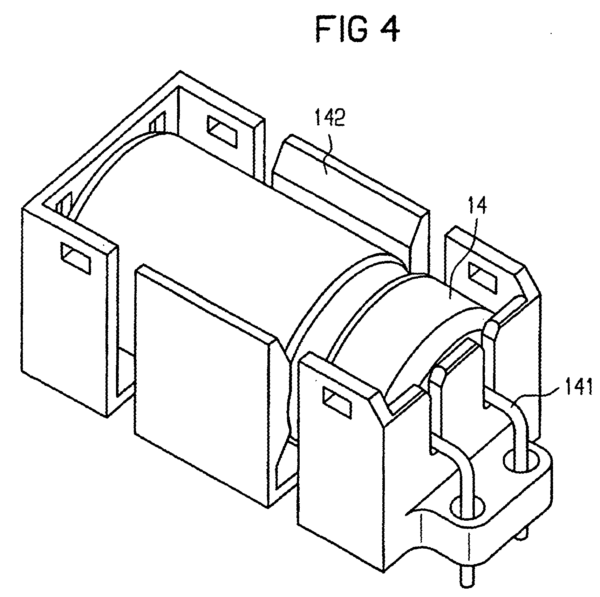

In Figur 3 ist ein Steckverbinder 1 dargestellt, der in dem Hohlraum 13 ein Bauelementengehäuse 142 aufnimmt. Vor dem Einbau des Bauelementengehäuses 142 in das Steckverbindergehäuse 11 wurde das bedrahtete Bauelement 14 in das Bauelementengehäuse eingesetzt. Das Bauelementengehäuse 142 ist wiederum im Steckverbindergehäuse 11 über Nasen 17 verrastet.

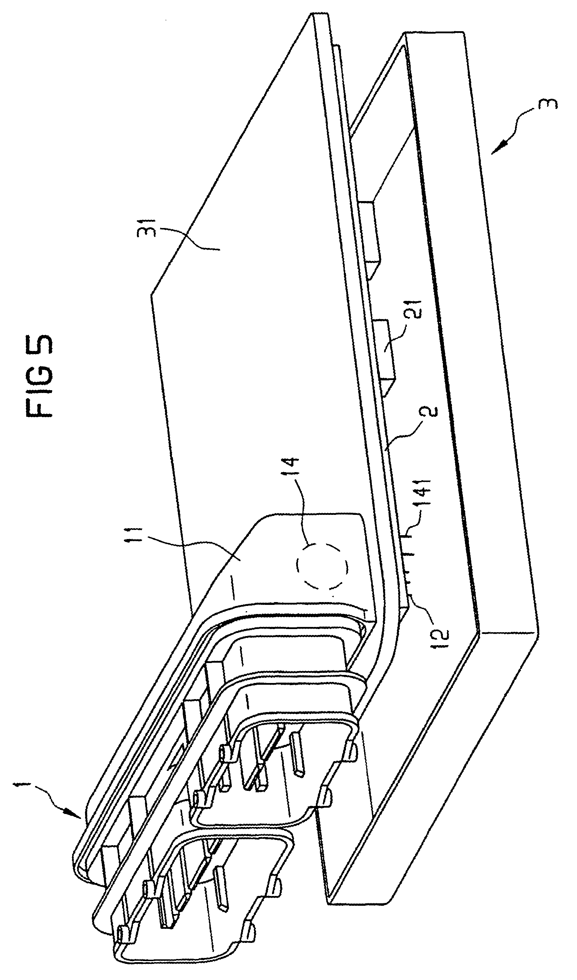

Figur 4 stellt einen in ein solches Bauelementengehäuse 142 eingesetzten Elektrolyt-Kondensator vor dem Einsetzen in ein Steckergehäuse dar. Der Kondensator ist reibschlüssig von mittleren, paralellen Wandabschnitten des Bauelementengehäuses 142 gehalten. Diese Wandabschnitte sind jeweils durch zwei Nute, die sich über einen Teil des Umfangs des Bauelementengehäuses erstrecken, von den Endstücken des Bauelementengehäuses abgegrenzt. Durch die Nute erlangt der Mittelabschnitt des Bauelementengehäuses 142 ausreichende Flexibilität, um sich beim Einsetzen des Elektrolyt-Kondensators oder des bedrahteten Bauelements 14 aufzubiegen.

Die Anschlußdrähte 141 des Elektrolyt-Kondensators verlaufen durch eine vertikale Nut einer Längswand des Bauelementengehäuses hindurch, sind außerhalb des Bauelementengehäuses um 90° gebogen und durch einen Fortsatz des Bauelementengehäuses ausgerichtet. Dieser Fortsatz weist vertikale Öffnungen zum Durchführen der Anschlußdrähte 141 auf. Die Achsen der vertikalen Löcher sind parallel zur Längswand des Bauelementengehäuses 142 ausgerichtet.

Figur 5 zeigt ein Steuergerät mit einem metallischen Gehäuse 3. Der Steckverbinder 1 weist ein haubenartiges Steckverbindergehäuse 11 auf, das einstückig mit einem metallischen Gehäusedeckel oder einer Gehäusewand 31 hergestellt ist. In dem Steckverbinder 1 ist ein bedrahtetes Bauelement 14 mit Anschlußdrähten 141 angeordnet. Sowohl die Anschlußdrähte 141 als auch die Enden der Kontaktstifte 12 ragen durch eine Leiterplatte 2.

Die Leiterplatte 2 ist mit einer Seite unmittelbar mittels eines Wärmeleitklebers auf einen Gehäusedeckel 31 geklebt. Die andere Seite der Leiterplatte 2 ist mit oberflächenmontierbaren Bauelementen 21 bestückt. Auf dieser Bestückungsseite ragen sowohl die Enden der Kontaktstifte 12 als auch die Anschlußdrähte 141 hervor. Sie können daher zusammen mit den oberflächenmontierbaren Bauelementen (SMDs) in einem Arbeitsgang in einem Reflow-Ofen gelötet werden. Das bedrahtete Bauelement 14 ist dabei durch den Steckverbinder 11 von unmittelbarer Hitzeeinwirkung im Ofen abgeschirmt.

Nach dem Lötprozeß wird der Gehäusedeckel mit dem Steckverbinder 1 und der Leiterplatte 2 auf ein wannenartiges Gehäuseteil gesetzt und das Gehäuse somit verschlossen. Das von dem wannenartigen Gehäuseteil und dem Gehäusedeckel 31 eingeschlossene Gehäusevolumen ist gering, so daß bei Erwärmung und Abkühlung des Steuergeräts nur ein geringer Luftaustausch mit der Umgebung nötig ist. Die Höhe des Gehäuses konnte sehr flach gehalten werden, da der relativ sperrige Elektrolyt-Kondensator außerhalb des Gehäuseinnenraums im Steckverbindergehäuse 11 untergebracht ist.

Auf der Leiterplatte 2 sind ausschließlich oberflächenmontierbare Bauelemente befestigt. Bedrahtete Bauelemente sind ausschließlich im Steckverbindergehäuse 11 untergebracht und sind dort mechanisch gehalten.

Aufgrund der Anbringung des bedrahteten Bauelements 14 im Steckergehäuse, kann das bedrahtete Bauelement 14 auf besonders einfache Weise vibrationssicher fixiert werden, da das Steckverbindergehäuse 11 eine weit bessere Abstützung als eine ebene Leiterplatte bereitstellen kann. Insbesondere kann das bedrahtete Bauelement 14 in dem Hohlraum 13 vergossen werden.

## Patentansprüche

1. Steuergerät mit einem Gehäuse (3), einer Leiterplatte (2), und einem Steckverbinder (1), der mit der Leiterplatte (2) mechanisch verbunden ist, wobei
ein bedrahtetes Bauelement (14) in einem Hohlraum (13) eines Steckverbindergehäuses (11) angeordnet ist, und
das bedrahtete Bauelement (14) an dem Steckverbindergehäuse (11) befestigt ist,
**dadurch gekennzeichnet,**
**daß** der Steckverbinder (1) eine Zentrierhilfe (15) mit einem Raster für Kontaktstifte (12) des Steckverbinders und für Anschlußdrähte (141) des bedrahteten Bauelements (14) aufweist, wobei das Raster der Zentrierhilfe (15) die Kontaktstifte (12) und die Anschlußdrähte (141) auf ein entsprechendes Raster der Leiterplatte (2) ausrichtet, und wobei auf der Leiterplatte oberflächenmontierbare Bauelemente (21) gelötet sind.

2. Steuergerät nach einem der vorhergehenden Ansprüche, **dadurch gekennzeichnet, daß** die oberflächenmontierbaren Bauelemente (21) und die bedrahteten Bauelemente (14) an dieselbe Leiterplatte (2) gelötet sind.

3. Steuergerät nach einem der vorhergehenden Ansprüche, **dadurch gekennzeichnet, daß** die Leiterplatte (2) an einem Gehäusedeckel (31) befestigt ist, und daß der Steckverbinder (1) derart an der von der Leiterplatte (2) abgewandten Seite des Gehäusedeckels (31) angeordnet ist, daß das bedrahtete Bauelement (14) außerhalb des vom Gehäuse (3) umschlossenen Innenraums angeordnet ist.

4. Steuergerät nach dem vorhergehenden Anspruch, **dadurch gekennzeichnet, daß** das Steckverbindergehäuse (11) und der Gehäusedeckel (31) aus einem einzigen Werkstück geformt sind.

5. Steuergerät nach einem der vorhergehenden Ansprüche, **dadurch gekennzeichnet, daß** das bedrahtete Bauelement (14) im Steckverbinder (1) verrastet ist.

6. Verfahren zum Löten von bedrahteten Bauelementen (14) und von oberflächenmontierbaren Bauelementen (21) auf eine Leiterplatte (2), mit den Schritten:
- die Leiterplatte (2) wird mit oberflächenmontierbaren Bauelementen (21) bestückt,
- ein bedrahtetes Bauelement (14) mit Anschlußdrähten (141) wird in einen Steckverbinder (1) mit Kontaktstiften (12) eingesetzt, wobei ein Raster einer Zentrierhilfe (15) die Kontaktstifte (12) und die Anschlußdrähte (141) auf ein entsprechendes Raster der Leiterplatten (2) ausrichtet,
- der Steckverbinder (1) wird auf der Leiterplatte (2) derart plaziert, daß dessen Kontaktstifte (12) und die Anschlußdrähte (141) des bedrahteten Bauelements (14) durch die Leiterplatte (2) hindurch ragen,
- die Kontaktstifte (12), die Anschlußdrähte (141) und die oberflächenmontierbaren Bauelemente (21) werden in einem gemeinsamen Arbeitsschritt auf die Leiterplatte (2) gelötet.

7. Verfahren nach dem vorhergehenden Anspruch, **dadurch gekennzeichnet, daß** das bedrahtete Bauelement (14) zunächst in ein Bauelementengehäuse (142) eingesetzt wird und anschließend das Bauelementengehäuse (142) in den Steckverbinder (1) eingesetzt wird.

## Claims

1. Control device with a housing (3), a printed circuit board (2) and a plug-in connector (1) which is mechanically connected to the printed circuit board (2), whereby
a leaded component (14) is located in a cavity (13) in a plug-in connector housing (11), and
the leaded component (14) is fixed to the plug-in connector housing (11),
**characterized in that**
the plug-in connector (1) has a centering aid (15) with a grid for contact pins (12) of the plug-in connector and for connecting wires (141) of the leaded component (14), whereby the grid of the centering aid (15) aligns the contact pins (12) and the connecting wires (141) to a corresponding grid on the printed circuit board (2), and whereby surface-mountable components (21) are soldered onto the printed circuit board.

2. Control device according to one of the preceding claims, **characterized in that** the surface-mountable components (21) and the leaded components (14) are soldered onto the same printed circuit board (2).

3. Control device according to one of the preceding claims, **characterized in that** the printed circuit board (2) is fixed to a housing cover (31), and that the plug-in connector (1) is located on the side of the housing cover (31) facing away from the printed circuit board (2) such that the leaded component (14) is located outside the interior space enclosed by the housing (3).

4. Control device according to the preceding claim, **characterized in that** the plug-in connector housing (11) and the housing cover (31) are formed from a single workpiece.

5. Control device according to one of the preceding claims, **characterized in that** the leaded component (14) is latched in the plug-in connector (1).

6. Method for soldering leaded components (14) and surface-mountable components (21) onto a printed circuit board (2), having the steps:
- the printed circuit board (2) is fitted with surface-mountable components (21),
- a leaded component (14) with connecting wires (141) is inserted into a plug-in connector (1) with contact pins (12), whereby a grid of a centering aid (15) aligns the contact pins (12) and the connecting wires (141) to a corresponding grid on the printed circuit boards (2),
- the plug-in connector (1) is placed on the printed circuit board (2) such that the contact pins (12) of said plug-in connector (1) and the connecting wires (141) of the leaded component (14) project through the printed circuit board (2),
- the contact pins (12), the connecting wires (141) and the surface-mountable components (21) are soldered onto the printed circuit board (2) in a single workstep.

7. Method according to the preceding claim, **characterized in that** the leaded component (14) is first inserted into a component housing (141) and then the component housing (142) is inserted into the plug-in connector (1).

## Revendications

1. Appareil de commande, comprenant un boîtier (3), une plaquette de circuits imprimés (2) et un connecteur multibroches (1) qui est connecté mécaniquement à la plaquette de circuits imprimés (2), dans lequel
un composant à connexion par fil (14) est placé dans une cavité (13) d'un boîtier de connecteur multibroches (11), et
le composant à connexion par fil (14) est fixé sur le boîtier de connecteur multibroches (11),
**caractérisé en ce que** le connecteur multibroches (1) comporte une aide de centrage (15) présentant une grille pour les broches de connexion (12) du connecteur multibroches et pour des fils de connexion (141) du composant à connexion par fil (14), la grille de l'aide de centrage (15) alignant les broches de contact (12) et les fils de connexion (141) à une grille correspondante de la plaquette de circuits imprimés (2), des composants à montage en surface (21) étant soudés sur la plaquette de circuits imprimés.

2. Appareil de commande selon l'une des revendications précédentes, **caractérisé en ce que** les composants à montage en surface (21) et les composants à connexion par fil (14) sont soudés sur la même plaquette de circuits imprimés (2).

3. Appareil de commande selon l'une des revendications précédentes, **caractérisé en ce que** la plaquette de circuits imprimés (2) est fixée sur un couvercle de boîtier (31), et que le connecteur multibroches (1) est placé de telle façon sur le côté du couvercle de boîtier (31) opposé à la plaquette de circuits imprimés (2) que le composant à connexion par fil (14) se trouve à l'extérieur de l'espace renfermé par le boîtier (3).

4. Appareil de commande selon la revendication précédente, **caractérisé en ce que** le boîtier de connecteur multibroches (11) et le couvercle de boîtier (31) sont formés d'une seule pièce ouvrée.

5. Appareil de commande selon l'une des revendications précédentes, **caractérisé en ce que** le composant à connexion par fil (14) est encliqueté dans le connecteur multibroches (1).

6. Procédé pour souder des composants à connexion par fil (14) et des composants à montage en surface (21) sur une plaquette de circuits imprimés (2), comportant les étapes suivantes:
- la plaquette de circuits imprimés (2) est équipée de composants à montage en surface (21),
- la plaquette de circuits imprimés (2) est équipée de composants à montage en surface (21),
- un composant à connexion par fil (14) ayant des fils de connexion (141) est inséré dans un connecteur multibroches (1) ayant des broches de contact (12), une grille d'une aide de centrage (15) alignant les broches de contact (12) aux fils de connexion (141) sur une grille correspondante des plaquettes de circuits imprimés (2),
- le connecteur multibroches (1) est placé sur la plaquette de circuits imprimés (2) de telle manière que ses broches de contact (12) et les fils de connexion (141) du composant à connexion par fil (14) traversent la plaquette de circuits imprimés (2),
- les broches de contact (12), les fils de connexion (141) et les composants à montage en surface (21) sont soudés dans une étape commune sur la plaquette de circuits imprimés (2).

7. Procédé selon la revendication précédente, **caractérisé en ce que** le composant à connexion par fil (14) est d'abord inséré dans un boîtier de composant (142), et le boîtier de composant (142) est ensuite inséré dans le connecteur multibroches (1).
